(19) Europäisches Patentamt
European Patent Office
Office européen des brevets

(11) **EP 2 826 080 B1**

(12) **EUROPÄISCHE PATENTSCHRIFT**

(45) Veröffentlichungstag und Bekanntmachung des Hinweises auf die Patenterteilung:
**18.09.2019   Patentblatt 2019/38**

(21) Anmeldenummer: **13709450.4**

(22) Anmeldetag: **15.03.2013**

(51) Int Cl.:
**H01L 51/52** *(2006.01)*

(86) Internationale Anmeldenummer:
**PCT/EP2013/055414**

(87) Internationale Veröffentlichungsnummer:
**WO 2013/135873 (19.09.2013 Gazette 2013/38)**

(54) **LICHTABGABEANORDNUNG MIT EINER OLED ODER QLED MIT VERBESSERTER LICHTAUSBEUTE**

LIGHT-EMITTING ARRANGEMENT WITH AN OLED OR QLED WITH IMPROVED LIGHT YIELD

SYSTÈME D'ÉMISSION DE LUMIÈRE COMPORTANT UNE OLED OU QLED AYANT UN RENDEMENT LUMINEUX AMÉLIORÉE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.03.2012   DE 102012204062**

(43) Veröffentlichungstag der Anmeldung:
**21.01.2015   Patentblatt 2015/04**

(73) Patentinhaber: **Tridonic GmbH & Co KG**
**6851 Dornbirn (AT)**

(72) Erfinder:
• **AMELUNG, Jörg**
**01099 Dresden (DE)**
• **DWORZAK, Matthias**
**63069 Offenbach (DE)**
• **ERITT, Michael**
**01129 Dresden (DE)**
• **KIRCHHOF, Christian**
**01099 Dresden (DE)**

(74) Vertreter: **Thun, Clemens**
**Mitscherlich PartmbB**
**Patent- und Rechtsanwälte**
**Sonnenstraße 33**
**80331 München (DE)**

(56) Entgegenhaltungen:
EP-A1- 1 486 802       EP-A1- 2 333 864
US-A1- 2007 046 181    US-A1- 2007 230 211
US-A1- 2011 068 357

**Beschreibung**

Die Erfindung betrifft eine Lichtabgabeanordnung mit einer Lichterzeugungsschicht einer OLED (organic light emitting diode; organische Leuchtdiode) oder QLED (quantum dot light emitting diode; Quantenpunkt-Leuchtdiode) und einer Randschicht, über die ein von der Lichterzeugungsschicht erzeugtes Licht in einen Außenraum der Lichtabgabeanordnung abgegeben wird. Außerdem betrifft die Erfindung ein Verfahren zur Herstellung einer solchen Lichtabgabeanordnung.

Auf der Basis von OLEDs oder QLEDs können neuartige Flächenlichtelemente verwirklicht werden. Als flächiger Leuchtkörper mit gegenüber einer LED (light emitting diode; Leuchtdiode) moderaterer Leuchtdichte ist eine OLED bzw. QLED besonders gut geeignet für die Herstellung flächiger, diffuser Lichtquellen. Insbesondere im professionellen Beleuchtungsbereich ist eine diffuse Beleuchtung eine neue Möglichkeit der Realisierung von großflächigen hochqualitativen Leuchten.

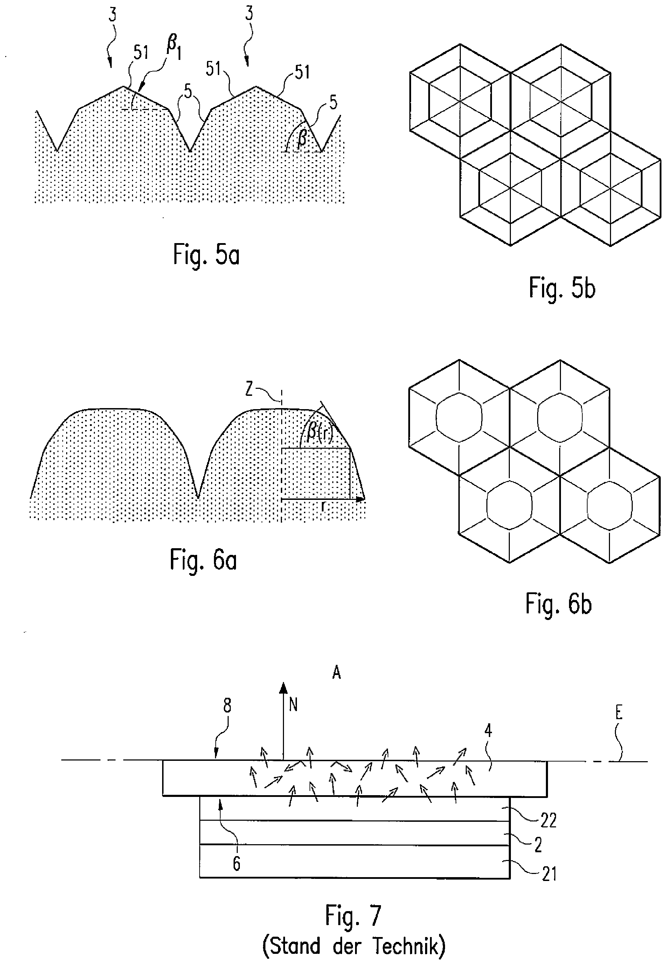

In Fig. 7 ist eine Skizze einer entsprechenden Lichtabgabeanordnung mit einer Lichterzeugungsschicht 2 einer OLED, also einer organischen Schicht und einer Randschicht 4 der Lichtabgabeanordnung - hier in Form eines Substrats - gezeigt. Die Randschicht 4 weist einen ersten Oberflächenbereich 6 auf, der zu der Lichterzeugungsschicht 2 weist und einen, dem ersten Oberflächenbereich 6 gegenüberliegenden zweiten Oberflächenbereich 8. Der zweite Oberflächenbereich 8 ist in erster Näherung in einer Ebene E verlaufend ausgebildet. Die OLED umfasst, wie an sich bekannt, zwei Elektroden 21, 22, wobei die Lichterzeugungsschicht 2 zwischen den beiden Elektroden 21, 22 angeordnet ist und bei Anlegen eines Stroms an die Elektroden 21, 22 ein Licht erzeugt. Das Licht tritt über den ersten Oberflächenbereich 6 in die Randschicht 4 ein und zumindest teilweise im Weiteren über den zweiten Oberflächenbereich 8 wieder aus der Randschicht 4 aus und wird in einen Außenraum A der Lichtabgabeanordnung abgegeben.

Üblicherweise grenzt der zweite Oberflächenbereich 8 unmittelbar an Luft, wobei der Brechungsindex $n$ der Randschicht 4 größer ist als der Brechungsindex der umgebenden Luft.

Die externe Lichtausbeute einer solchen Lichtabgabeanordnung ist aufgrund unterschiedlicher Verlustmechanismen begrenzt; analoges gilt im Fall einer QLED. Einer der dominierenden Verlustmechanismen ist dabei die Totalreflexion des Lichts an dem ersten Oberflächenbereich 8. Wie in Fig. 7 - lediglich sehr schematisch - durch kleine Pfeile angedeutet, breitet sich das Licht innerhalb der Randschicht 4 nicht lediglich in einer Richtung aus, sondern in vielen unterschiedlichen Richtungen. Zur diesbezüglichen Beschreibung wird hier eine, von der Lichterzeugungsschicht 2 fort weisende Normale $N$ der Ebene $E$ betrachtet; die Normale $N$ ist also in Richtung Außenraum $A$ gerichtet. Das innerhalb der Randschicht 4 verlaufende Licht setzt sich dementsprechend aus vielen Lichtstrahlen zusammen, die jeweils einen Winkel $\alpha$ mit der Normalen $N$ einschließen.

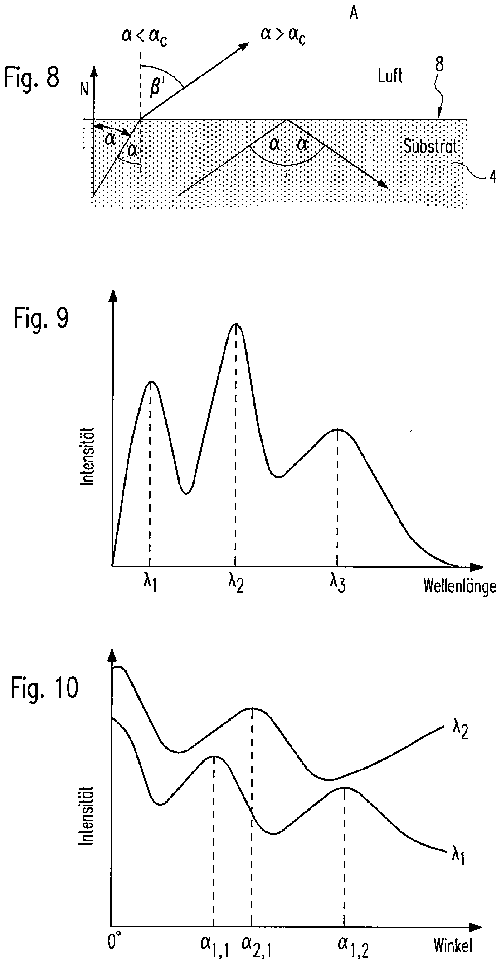

Wenn nun, wie in Fig. 8 näher skizziert, ein Lichtstrahl unter einem Winkel $\alpha$ aus der Randschicht 4 - hier in Form des Substrats - auf den ersten Oberflächenbereich 8 trifft, kommt es zu einer Totalreflexion, falls der Winkel $\alpha$ größer als der entsprechende kritische Winkel $\alpha_C$ ist. Der Lichtstrahl wird in diesem Fall also totalreflektiert und im Weiteren innerhalb der Randschicht 4 zumindest teilweise absorbiert; dieser Vorgang kann sich mehrfach wiederholen, bis das gesamte unter dem Winkel $\alpha$ abgestrahlte Licht absorbiert ist.

Falls der Lichtstrahl unter einem Winkel $\alpha$ auf den ersten Oberflächenbereich 8 trifft, der kleiner als der kritische Winkel $\alpha_C$ ist, wird der Lichtstrahl unter dem Austrittswinkel $\beta'$ gebrochen und gelangt so in den Außenraum $A$.

Aus dem Stand der Technik ist es bekannt, diese Verluste durch spezielle Auskoppeloptiken an der OLED- bzw. QLED-Oberfläche zu vermindern. Eine derartige Auskoppeloptik ist beispielsweise aus der Schrift US 2003/0020399 A1 bekannt. Bei dieser bekannten Auskoppeloptik sind optische Elemente auf dem zweiten Oberflächenbereich 8 angeordnet, die die Form von Pyramidenstümpfen aufweisen.

Auch die EP 1 486 802 A1 zeigt eine Lichtabgabeanordnung, bei der optische Elemente auf dem zweiten Oberflächenbereich ausgebildet sind, wobei die optischen Elemente Flächenbereiche aufweisen, die einen Steigungswinkel (90° - Θ) größer 0° gegenüber der Ebene aufweisen. Der Steigungswinkel (90° - Θ) ist dabei derart gewählt, dass die Intensität des Lichts in Abhängigkeit des Winkels, unter dem sich das Licht mit Bezug auf eine, von der Lichterzeugungsschicht fort weisende Normale der Ebene ausbreitet, ihr Maximum aufweist. Bei einer aus der US 2007/0230211 A1 bekannten Anordnung kommen als Auskoppeloptiken Prismen zum Einsatz, wobei durch Variation eines entsprechenden Prismenwinkels eine maximale Intensität des vorwärts gerichteten Lichts ermittelt wird.

Schließlich zeigt die US 2007/0046181 A1 eine OLED-Lichtabgabeanordnung, bei der wiederum auf der dem OLED-Material abgewandten Seite einer Randschicht abgewinkelt ausgebildet Pyramidenstümpfe vorgesehen sind, mit deren Hilfe die Auskopplung des Lichts und damit die Effizienz der Lichtabgabe optimiert werden soll.

Teilweise wird durch die bekannten Auskoppeloptiken eine deutliche Verbesserung der externen Lichtausbeute der Lichtabgabeanordnung erzielt. Allerdings kommt es auch zu Fällen, in denen sich auf diese Weise lediglich eine sehr geringe oder keine merkliche Verbesserung erzielen lässt.

Der Erfindung liegt die Aufgabe zugrunde, eine entsprechend weiter verbesserte Lichtabgabeanordnung anzugeben; insbesondere soll die Lichtabgabeanordnung verbesserte Eigenschaften mit Bezug auf die externe Lichtausbeute aufweisen. Außerdem soll ein Verfahren zur Herstellung einer solchen Lichtabgabeanordnung angegeben werden.

Diese Aufgabe wird gemäß der Erfindung mit den in den unabhängigen Ansprüchen angegebenen Gegenständen gelöst. Besondere Ausführungsarten der Erfindung sind in den abhängigen Ansprüchen angegeben.

Die Ursache für die teilweise deutlich begrenzte Wirkung der bekannten Auskoppeloptiken mit Bezug auf die Lichtausbeute liegt darin, dass es eine große Vielfalt an unterschiedlich aufgebauten Typen von OLEDs und QLEDs gibt, die sich in ihren optischen Eigenschaften unterscheiden. Diese optischen Eigenschaften lassen sich zum Beispiel durch das Spektrum und die Winkelverteilung des Lichts innerhalb der Randschicht charakterisieren. Sowohl das Spektrum, als auch die Winkelverteilung hängen in komplexer Weise von unterschiedlichen Parametern ab, zum Beispiel Material und Schichtdicke und sind daher für jeden OLED- bzw. QLED-Typ spezifisch.

Fig. 9 zeigt beispielhaft ein Emissionsspektrum einer OLED/QLED. Dabei ist die Intensität $I$ des Lichts in der Randschicht als Funktion der Wellenlänge $\lambda$ aufgetragen. Das Spektrum weist ausgeprägte Maxima und Minima auf. Im gezeigten Beispiel ist ein absolutes Maximum bei der Wellenlänge $\lambda_2$ zu erkennen und außerdem zwei lokale Maxima bei den Wellenlängen $\lambda_1$ und $\lambda_3$. Das Maximum bei der Wellenlänge $\lambda_1$ ist dabei das zweitgrößte Maximum, dasjenige bei der Wellenlänge $\lambda_3$ das drittgrößte Maximum.

Des Weiteren wird das innerhalb der Randschicht verlaufende Licht jeder einzelnen Wellenlänge $\lambda$ (bzw. integralen Wellenlängenlängenintervalls $\lambda$) durch die genannte Abhängigkeit vom Winkel $\alpha$ charakterisiert. Die Intensität $I$ des Lichts innerhalb der Randschicht lässt sich somit - wie in Fig. 10 beispielhaft skizziert - als Funktion der Wellenlänge $\lambda$ und des Winkels $\alpha$ beschreiben, also mathematisch formuliert $I = I(\lambda, \alpha)$. Im gezeigten Beispiel sind für Winkel $\alpha > 0°$ drei Maxima erkennbar, nämlich ein absolutes Maximum bei $\lambda = \lambda_2$ und $\alpha = \alpha_{2,1}$, also an der Stelle $(\lambda_2, \alpha_{2,1})$ und zwei weitere, lokale Maxima finden sich bei $\lambda = \lambda_1$ und $\alpha = \alpha_{1,1}$ und bei $\lambda = \lambda_1$ und $\alpha = \alpha_{1,2}$, also an den Stellen $(\lambda_1, \alpha_{1,1})$ und $(\lambda_1, \alpha_{1,2})$.

Gemäß der Erfindung wird nun ausgehend von der in Fig. 7 skizzierten Lichtabgabeanordnung die Gestaltung der Auskoppeloptik zur Auskopplung des Lichts aus der Randschicht in die umgebende Luft des Außenraums $A$ an die OLED/QLEDspezifische Funktion $I(\lambda, \alpha)$ angepasst ausgebildet.

Hierzu sind optische Elemente in Form von Mikroprismen auf dem zweiten Oberflächenbereich angeordnet oder ausgebildet, die Flächenbereiche mit einem Steigungswinkel $\beta$ gegenüber der Ebene $E$ aufweisen, der größer als 0° ist, wobei die Mikroprismen derart ausgebildet sind, dass der Steigungswinkel $\beta$ die folgende Relation erfüllt:

$$n(\lambda_0) \sin (\beta - \alpha_0) = \sin (\beta), \qquad \text{(Gleichung 1)}$$

wenn die Funktion $I = I(\lambda, \alpha)$ mit $\alpha > 0°$ bei der Wellenlänge $\lambda_0$ und dem Winkel $\alpha_0$ ihr absolutes Maximum aufweist und $n(\lambda_0)$ den Brechungsindex der optischen Elemente bei der Wellenlänge $\lambda_0$ bezeichnet.

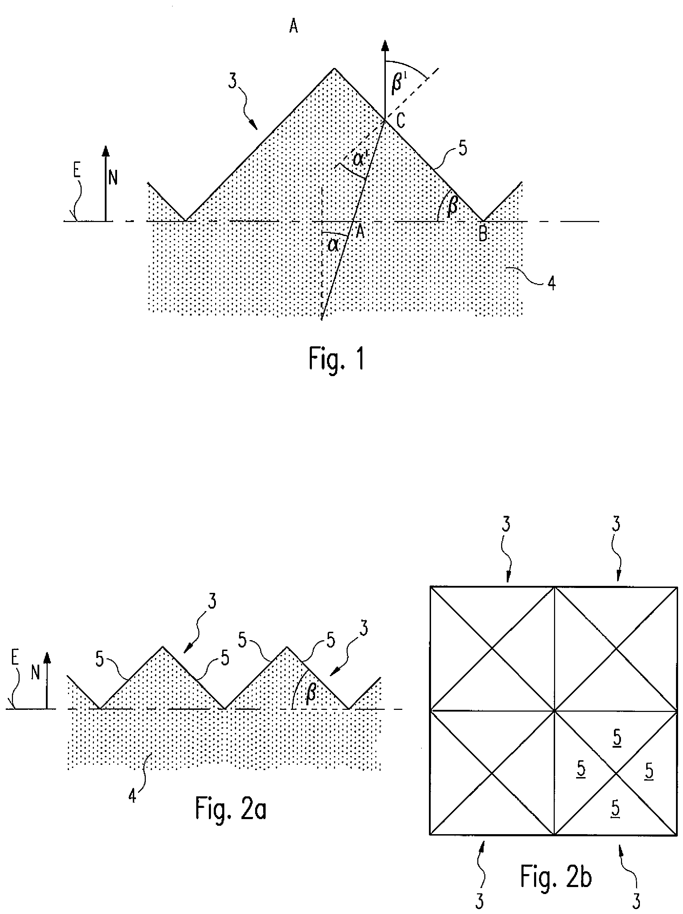

Zur Erläuterung der in Gleichung (1) genannten Relation ist in Fig. 1 beispielhaft ein Lichtstrahl skizziert, der unter dem Winkel $\alpha$ in der Randschicht 4 verläuft und dann auf einen entsprechenden Flächenbereich 5 eines optischen Elements 3 trifft, der einen Steigungswinkel $\beta$ gegenüber der Ebene $E$ aufweist, so dass der Lichtstrahl unter dem Eintrittswinkel $\alpha'$ auf die Grenzfläche zur Luft trifft, dort gebrochen wird und dann unter dem Austrittswinkel $\beta'$ weiterverläuft. Im gezeigten Beispiel ist das optische Element 3 auf dem zweiten Oberflächenbereich 8 ausgebildet, wobei es einstückig mit der Randschicht 4 gebildet ist.

Wenn nun - wie in der Skizze gezeigt - der in den Außenraum $A$ austretende Lichtstrahl parallel zu der Normalen $N$ verläuft, ist $\beta'$ gleich dem Steigungswinkel $\beta$ des Flächenbereichs 5 und es gilt im Dreieck $ABC$ für die Winkelsumme

$$180° = \beta + (90° - \alpha) + (90° - \alpha')$$

und folglich die Beziehung

$$\alpha' = \beta - \alpha.$$

Der Steigungswinkel $\beta$ ist also so gewählt, dass das Licht "in Vorwärtsrichtung", also senkrecht zu der Ebene $E$, gebrochen wird bzw. in Richtung der Normalen $N$ in den Außenraum $A$ tritt. Mithilfe des Snellius Brechungsgesetzes ergibt sich somit für diesen Fall die Beziehung

$$n(\lambda) \sin (\beta - \alpha) = \sin (\beta),$$

wenn $n(\lambda)$ den Brechungsindex des optischen Elements 3 bzw. - bei entsprechender einstückiger Ausbildung - der Randschicht 4 bei der Wellenlänge $\lambda$ bezeichnet und der Brechungsindex im Außenraum $A$ den Wert 1 hat.

Wenn der Steigungswinkel $\beta$ entsprechend der obigen Gleichung (1) für das absolute Maximum der Funktion $I = I(\lambda, \alpha)$, $\alpha > 0°$, festgelegt wird, lässt sich somit unter vergleichsweise einfacher Ausbildung der optischen Elemente ein vergleichsweise großer Effekt mit Bezug auf die Lichtausbeute erzielen.

Dabei weisen die Mikroprismen erfindungsgemäß weitere Flächenbereiche auf, die einen weiteren Steigungswinkel $\beta_1$ aufweisen, der sich von dem zuerst genannten Steigungswinkel $\beta$ unterscheidet, wobei die Mikroprismen derart ausgebildet sind, dass der weitere Steigungswinkel $\beta_1$ mit Bezug auf ein lokales Maximum der Funktion $I = I(\lambda, \alpha)$, $\alpha > 0°$, das nicht das absolute Maximum ist, analog zu dem zuerst genannten Steigungswinkel $\beta$ gewählt ist, wobei das lokale Maximum vorzugsweise das zweitgrößte Maximum der Funktion $I = I(\lambda, \alpha)$, $\alpha > 0°$, ist. Hierdurch lässt sich eine weitergehende Steigerung der Lichtausbeute erzielen.

Vorzugsweise handelt es sich bei der Randschicht um ein Substrat. Dabei ist vorzugsweise zwischen dem Substrat und der Lichterzeugungsschicht - insbesondere lediglich - eine Elektrode der OLED bzw. QLED angeordnet.

Vorteilhaft sind die Mikroprismen einstückig mit der Randschicht ausgebildet oder aus einem Material gefertigt, das zumindest näherungsweise denselben Brechungsindex aufweist wie dasjenige Material, aus dem die Randschicht besteht. Auf diese Weise lassen Sich unerwünschte Effekte am Übergangsbereich von der Randschicht zu den optischen Elementen vermeiden.

Vorzugsweise sind die Mikroprismen unmittelbar aneinander grenzend angeordnet. Hierdurch ist der optische Effekt, der sich durch die Mikroprismen erzielt lässt, besonders gut ausgeprägt.

Die Größe bzw. der Durchmesser der Mikroprismen ist vorzugsweise kleiner als 1 mm, besonders bevorzugt kleiner als 0,1 mm.

Eine besonders einfache und dabei wirkungsvolle Gestaltungsmöglichkeit der Mikroprismen ist ermöglicht, wenn die Mikroprismen jeweils eine Pyramidenform aufweisen, wobei die Flächenbereiche jeweils wenigstens eine Mantelfläche der entsprechenden Pyramide darstellen.

Vorzugsweise weist die Pyramidenform eine dreieckige oder eine rechteckige oder eine hexagonale Grundfläche auf. Auf diese Weise lassen sich die Mikroprismen besonders gut unmittelbar aneinander angrenzend gestalten, so dass zwischen den optischen Elementen praktisch keine Zwischenbereiche gebildet sind, in denen es zu unerwünschten optischen Effekten kommen könnte.

Besonders einfach und dabei wirkungsvoll lassen sich die Mikroprismen gestalten, wenn wenigstens zwei der Mantelflächen, vorzugsweise sämtliche Mantelflächen der entsprechenden Pyramide denselben Steigungswinkel $\beta$ gegenüber der Ebene aufweisen.

In einer entsprechenden weiteren Fortbildung weisen die Mikroprismen außerdem noch weitere Flächenbereiche auf, die wenigstens einen noch weiteren Steigungswinkel $\beta_i$ aufweisen, der sich von dem zuerst genannten Steigungswinkel $\beta$ und dem weiteren Steigungswinkel $\beta_1$ unterscheidet, wobei die Mikroprismen derart ausgebildet sind, dass der noch weitere Steigungswinkel $\beta_i$ bzw. jeder der noch weiteren Steigungswinkel $\beta_i$ mit Bezug auf ein lokales Maximum der Funktion $I = I(\lambda, \alpha)$, $\alpha > 0°$, das nicht das absolute Maximum und nicht das zuerst genannte lokale Maximum ist, analog zu dem zuerst genannten Steigungswinkel $\beta$ gewählt ist.

Besonders effektiv lässt sich die Lichtabgabeanordnung gestalten, wenn die Mikroprismen dabei derart gestaltet sind, dass zu jedem lokalen Maximum der Funktion $I = I(\lambda, \alpha)$, $\alpha > 0°$, jeweils Flächenbereiche mit einem der Steigungswinkel ausgebildet sind.

Gemäß der Erfindung ist also eine Lichtabgabeanordnung vorgesehen, die eine Lichterzeugungsschicht einer OLED oder einer QLED aufweist, die dazu ausgebildet ist, bei Anlegen eines Stroms ein Licht zu erzeugen, eine Randschicht, die in erster Näherung plattenförmig ist, so dass sie einen ersten Oberflächenbereich und einen, dem ersten Oberflächenbereich gegenüberliegenden, zweiten Oberflächenbereich aufweist, wobei der zweite Oberflächenbereich in erster Näherung in einer Ebene verlaufend ausgebildet ist, wobei das Licht der Lichterzeugungsschicht über den ersten Oberflächenbereich in die Randschicht eintritt, über den zweiten Oberflächenbereich aus der Randschicht austritt und in einen Außenraum der Lichtabgabeanordnung abgegeben wird, sowie optische Elemente, die auf dem zweiten Oberflächenbereich angeordnet oder ausgebildet sind, wobei die optischen Elemente Mikroprismen sind, welche Flächenbereiche aufweisen, die einen Steigungswinkel größer als 0° gegenüber der Ebene aufweisen. Der Steigungswinkel $\beta$ ist dabei derart gewählt, dass er die Relation $n(\lambda_G) \sin(\beta - \alpha_0) = \sin(\beta)$ erfüllt, wenn die Funktion $I_{\lambda G} = I_{\lambda G}(\alpha)$, $\alpha > 0°$, die die Intensität $I_{\lambda G}$ des Lichts innerhalb der Randschicht bei einer vorgegebenen Wellenlänge $\lambda_G$ in Abhängigkeit des Winkels $\alpha$ angibt, unter dem sich das Licht mit Bezug auf eine, von der Lichterzeugungsschicht fort weisende Normale der Ebene ausbreitet, bei dem Winkel $\alpha_0$ ein Maximum, vorzugsweise ihr absolutes Maximum aufweist und $n(\lambda_G)$ den Brechungsindex der Mikroprismen bei der Wellenlänge $\lambda_G$ bezeichnet, wobei die optischen Mikroprismen außerdem weitere Flächenbereiche aufweisen, die einen weiteren Steigungswinkel β1 aufweisen, der sich von dem zuerst genannten Steigungswinkel β unterscheidet, wobei die Mikroprismen derart ausgebildet sind, dass der weitere Steigungswinkel β1 mit Bezug auf ein lokales Maximum der Funktion $I = I(\lambda, \alpha)$, $\alpha > 0°$, das nicht das absolute Maximum ist, analog zu dem zuerst genannten Steigungswinkel β gewählt ist, wobei das lokale Maximum vorzugsweise das zweitgrößte Maximum der Funktion $I = I(\lambda, \alpha)$, $\alpha > 0°$, ist.

Gemäß einem noch weiteren Aspekt der Erfindung ist ein Verfahren zur Herstellung einer erfindungsgemäßen Lichtabgabeordnung vorgesehen, das die folgenden Schritte aufweist: (i) Ermittlung der Funktion $I = I(\lambda, \alpha)$ mit $\alpha > 0°$, (ii) Ermittlung des absoluten Maximums der Funktion und (iii) Festlegung des Steigungswinkels $\beta$ in Abhängigkeit des Maximums der Funktion gemäß der genannten Relation. Vorzugsweise ist das Verfahren zur Herstellung einer entsprechenden erfindungsgemäßen Lichtabgabeanordnung ausgebildet, bei der die optischen Elemente wenigstens Flächenbereiche mit zwei unterschiedlichen Steigungswinkeln aufweisen, wobei das Verfahren außerdem noch die beiden folgenden Schritte umfasst: (iv) Ermittlung wenigstens eines lokalen Maximums der Funktion, das nicht das absolute Maximum darstellt, vorzugsweise wenigstens des zweitgrößten Maximums, und (v) analoge Festlegung wenigstens eines weiteren Steigungswinkels $\beta, \beta_i$ in Abhängigkeit des wenigstens einen weiteren lokalen Maximums.

Vorzugsweise werden die optischen Elemente mithilfe von Spritzguss oder Stereolithographie hergestellt.

Die Erfindung wird im Folgenden anhand von Ausführungsbeispielen und mit Bezug auf die Zeichnungen näher erläutert. Es zeigen:

| | |
|---|---|
| Fig. 1 | eine Prinzip-Querschnittskizze zu optischen Elementen einer Lichtabgabeanordnung, |
| Fig. 2a | eine entsprechende Querschnitt-Skizze zu einem ersten Ausführungsbeispiel, |
| Fig. 2b | eine dazugehörige Aufsicht, |
| Figuren 3a und 3b | den Figuren 2a und 2b entsprechende Skizzen zu einem zweiten Ausführungsbeispiel, |
| Figuren 4a und 4b | den Figuren 2a und 2b entsprechende Skizzen zu einem dritten Ausführungsbeispiel, |
| Figuren 5a und 5b | den Figuren 2a und 2b entsprechende Skizzen zu einem vierten Ausführungsbeispiel, |
| Figuren 6a und 6b | den Figuren 2a und 2b entsprechende Skizzen zu einem fünften Ausführungsbeispiel, |
| Fig. 7 | eine Skizze einer Lichtabgabeanordnung gemäß dem Stand der Technik, |
| Fig. 8 | eine Skizze zum optischen Verhalten von Lichtstrahlen an einer Grenzfläche zwischen einer Randschicht einer Lichtabgabeanordnung und umgebender Luft, |
| Fig. 9 | ein Diagramm zur Abhängigkeit der Intensität des Lichts innerhalb der Randschicht in Abhängigkeit der Wellenlänge und |
| Fig. 10 | ein entsprechendes Diagramm, in dem die Abhängigkeit von der Wellenlänge und dem Winkel $\alpha$ gegenüber einer Normalen der Lichtabgabeanordnung skizziert ist. |

In Fig. 2a (nicht Teil dieser Erfindung) ist eine Skizze zu einem ersten Ausführungsbeispiel gezeigt, die der Darstellung der Fig. 1 entspricht, also einen entsprechenden Querschnitt im Bereich des zweiten Oberflächenbereichs 8 zeigt. In Fig. 2b ist eine entsprechende Aufsicht von dem Außenraum A auf den zweiten Oberflächenbereich 8 skizziert.

Ausgehend von der oben dargestellten, in Fig. 7 skizzierten Lichtabgabeanordnung gemäß dem Stand der Technik und den obigen Ausführungen sind auf dem zweiten Oberflächenbereich 8 optische Elemente 3 angeordnet oder ausgebildet, die Flächenbereiche 5 mit einem Steigungswinkel $\beta$ gegenüber der Ebene E aufweisen, der größer als 0° ist, wobei der Steigungswinkel $\beta$ die oben in Gleichung (1) angegebene Relation erfüllt. Auf diese Weise ist der Steigungswinkel $\beta$ derart gewählt, dass er an die maximale Intensität $I$ des Lichts in der Randschicht 4 angepasst ist bzw. an das absolute Maximum der Funktion $I = I(\lambda, \alpha)$ mit $\alpha > 0°$.

Die Randschicht 4 besteht vorzugsweise lediglich aus einem quasi homogen verteilten Material, so dass die Randschicht 4 an allen Stellen denselben Brechungsindex in Abhängigkeit der Wellenlänge des Lichts aufweist. Vorzugsweise handelt es sich bei der Randschicht um ein Substrat. Vorzugsweise ist - wie in Fig. 7 skizziert - zwischen dem Substrat und der Lichterzeugungsschicht 2 eine Elektrode 22, insbesondere lediglich eine Elektrode 22 angeordnet, wobei die Elektrode 22 vorzugsweise eine Elektrode ist, die zum Anlegen des Stroms zur Erzeugung des Lichts in der Lichterzeugungsschicht 2 dient.

Im gezeigten Beispiel sind die optischen Elemente 3 einstückig mit der Randschicht 4 ausgebildet, also durch entsprechende Strukturierung des zweiten Oberflächenbereichs 8 der Randschicht 4 gebildet. Dies hat den Vorteil, dass - unter normalen Umständen - der Brechungsindex der optischen Elemente 3 praktisch identisch zu dem Brechungsindex der Randschicht 4 ist, so dass es zu keinen weiteren, möglicherweise unerwünschten, optischen Beeinflussungen im Bereich des Übergangs von der Randschicht 4 zu den optischen Elementen 3 kommt.

Alternativ können die optischen Elemente 3 als separate Elemente gestaltet sein, wobei es in diesem Fall vorteilhaft ist, die optischen Elemente 3 derart zu gestalten, dass ihr Brechungsindex möglichst wenig von dem Brechungsindex der Randschicht 4 abweicht, also zumindest näherungsweise demjenigen der Randschicht 4 entspricht, so dass es nicht zu merklichen weiteren Beeinflussungen des Lichts in dem genannten Übergangsbereich kommt. Hierdurch könnte der gewünschte Effekt vermindert werden. Beispielsweise kann im Fall der separaten Ausbildung der optischen Elemente 3 vorgesehen sein, dass die optischen Elemente einen (über den sichtbaren Bereich gemittelten) Brechungsindex aufweisen, der weniger als 0,05, vorzugsweise weniger als 0,02 von demjenigen der Randschicht 4 abweicht.

Die optischen Elemente 3 sind bei diesem Ausführungsbeispiel pyramidenförmig und dabei vorzugsweise unmittelbar aneinander grenzend angeordnet. Somit lassen sich Flächenbereiche vermeiden, die parallel zu der Ebene *E* verlaufen. Die optischen Elemente 3 bilden somit quasi ein zweidimensionales optisches System zur Auskopplung des Lichts aus der Lichtabgabeanordnung in den Außenraum *A*.

Vorzugsweise sind die optischen Elemente 3 Mikroprismen. Die Grundfläche der entsprechenden Pyramide beträgt vorzugsweise zwischen 1 $\mu$m$^2$ und 1 mm$^2$, beispielsweise etwa 100 $\mu$m$^2$. Insbesondere kann die Größe bzw. der Durchmesser der optischen Elemente 3 kleiner als 1 mm sein, insbesondere kleiner als 0,1 mm.

Die Flächenbereiche 5 stellen jeweils wenigstens eine, vorzugsweise wenigstens zwei der Mantelflächen der entsprechenden Pyramide dar. Vorzugsweise weisen sämtliche Mantelflächen der entsprechenden Pyramide den Steigungswinkel $\beta$ auf. Dabei kann es sich insbesondere um eine gerade Pyramide handeln.

Wie aus Fig. 2b hervorgeht, weisen die optischen Elemente 3 bzw. die entsprechenden Pyramiden jeweils eine rechteckige, hier quadratische Grundfläche auf. Alle Pyramiden sind gleich geformt und gleich groß, so dass eine besonders einfache Herstellung ermöglicht ist.

Gemäß einer Variante kann vorgesehen sein, dass der Steigungswinkel $\beta$ derart gewählt ist, dass er die Relation $n(\lambda_G) \sin(\beta - \alpha_0) = \sin(\beta)$ erfüllt, wenn $\lambda_G$ eine vorgegebene Wellenlänge des Lichts bezeichnet, $n(\lambda_G)$ den Brechungsindex der optischen Elemente 3 für Licht der Wellenlänge $\lambda_G$ und $\alpha_0$ denjenigen Winkel unter dem die Funktion $I_{\lambda G} = I_{\lambda G}(\alpha)$ mit $\alpha > 0°$, die die Intensität $I_{\lambda G}$ des Lichts bei der vorgegebenen Wellenlänge $\lambda_G$ in Abhängigkeit des Winkels $\alpha$ angibt, ein Maximum, vorzugsweise ihr absolutes Maximum aufweist. Dies ist besonders vorteilhaft, wenn die Verbesserung der Lichtausbeute mit Bezug auf eine bestimmte Wellenlänge, hier also die Wellenlänge $\lambda_G$, erzielt werden soll.

Zur Herstellung der Lichtabgabeanordnung wird dementsprechend in einem Schritt (i) die Funktion $I = I(\lambda, \alpha)$ mit $\alpha > 0°$ ermittelt, also diejenige Funktion, die die Abhängigkeit des Lichts innerhalb der Randschicht 4 von der Wellenlänge $\lambda$ und dem Winkel $\alpha$ beschreibt. In einem anschließenden Schritt (ii) wird dann das absolute Maximum dieser Funktion ermittelt, also das Wertepaar $(\lambda_0, \alpha_0)$ das die Stelle des absoluten Maximums der Funktion $I = I(\lambda, \alpha)$ angibt, und in einem weiteren, nachfolgenden Schritt (iii) wird der Steigungswinkel $\beta$ in Abhängigkeit des absoluten Maximums der Funktion festgelegt. Hierzu dient dementsprechend die in Gleichung (1) angegebene Relation, wobei $n(\lambda_0)$ den Brechungsindex der optischen Elemente 3 bei der Wellenlänge $\lambda_0$ bezeichnet.

Die optischen Elemente 3 können vorteilhaft mithilfe von Spritzguss oder Stereolithographie hergestellt werden.

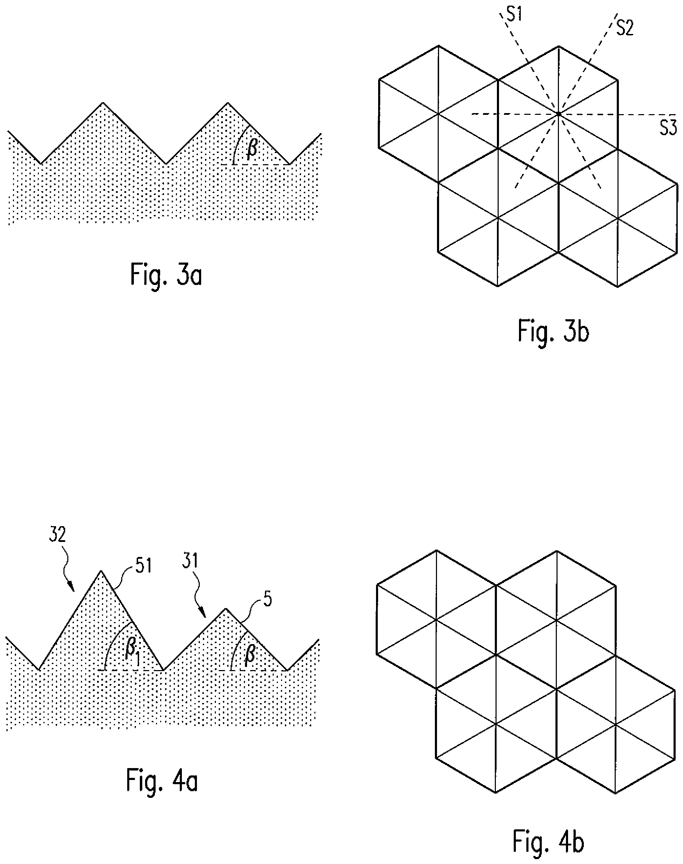

In den Figuren 3a und 3b (nicht Teil dieser Erfindung), die den Figuren 2a und 2b entsprechende Skizzen zeigen, ist ein zweites Ausführungsbeispiel dargestellt. Im Folgenden wird lediglich auf die Unterschiede zum ersten Ausführungsbeispiel eingegangen.

Bei diesem Beispiel weisen die optischen Elemente - hier ebenfalls mit dem Bezugszeichen 3 versehen - hexagonale Grundflächen auf. Ansonsten entspricht das zweite Ausführungsbeispiel dem ersten Ausführungsbeispiel.

Im Fall einer hexagonalen Grundfläche lassen sich die optischen Elemente 3 derart gestalten, dass die im Querschnitt der Fig. 1 dargestellten Zusammenhänge in drei, senkrecht zu der Ebene *E* verlaufenden, in Fig. 3b bezeichneten, Schnittebenen *S1, S2,* S3 berücksichtigt werden können, während sich im Fall einer quadratischen Grundfläche lediglich zwei entsprechende Schnittebenen ergeben. Insoweit ist eine hexagonale Grundfläche noch besser geeignet als eine quadratische bzw. rechtwinklige.

In den Figuren 4a und 4b, die den Figuren 2a und 2b entsprechende Skizzen zeigen, ist ein drittes Ausführungsbeispiel dargestellt. Im Folgenden wird lediglich auf die Unterschiede zu den vorherigen Ausführungsbeispielen eingegangen.

Bei diesem Ausführungsbeispiel weisen die optischen Elemente 3 außer den zuerst genannten Flächenbereichen 5 mit dem Steigungswinkel $\beta$ noch weitere Flächenbereiche 51 auf, die einen weiteren Steigungswinkel $\beta_1$ aufweisen, der sich von dem zuerst genannten Steigungswinkel $\beta$ unterscheidet. Die optischen Elemente 3 sind dabei derart ausgebildet, dass der weitere Steigungswinkel $\beta_1$ mit Bezug auf ein lokales Maximum der Funktion $I = I(\lambda, \alpha), \alpha > 0°$, das nicht das absolute Maximum ist, analog zu dem zuerst genannten Steigungswinkel $\beta$ gewählt ist, wobei das lokale Maximum vorzugsweise das zweitgrößte Maximum der Funktion $I = I(\lambda, \alpha), \alpha > 0°$, ist. Bezeichne also das Wertepaar $(\lambda_1, \alpha_1)$ die Stelle des lokalen Maximums, insbesondere des zweitgrößten Maximums der Funktion, dann ist der weitere Steigungswinkel $\beta_1$ derart festgelegt, dass die Relation $n(\lambda_1) \sin(\beta_1 - \alpha_1) = \sin(\beta_1)$ erfüllt ist, wobei $n(\lambda_1)$ den Brechungsindex der optischen Elemente 3 bei der Wellenlänge $\lambda_1$ bezeichnet.

Dementsprechend sind bei diesem Ausführungsbeispiel die optischen Elemente 3 in zwei unterschiedlichen Formen gebildet, nämlich in einer ersten Pyramidenausbildung 31, bei der die Mantelflächen den zuerst genannten Steigungswinkel $\beta$ bezüglich der Ebene E aufweisen und in einer zweiten Pyramidenausbildung 32, bei der die Mantelflächen den weiteren Steigungswinkel $\beta_1$ bezüglich der Ebene E aufweisen.

Vorzugsweise sind die optischen Elemente 3 dabei derart gebildet, dass - wie beispielhaft aus Fig. 4b hervorgeht - die erste Pyramidenausbildung 31 und die zweite Pyramidenausbildung 32 identische, gleich große Grundflächen aufweisen. Auf diese Weise lassen sich die optischen Elemente 3 wieder ohne Zwischenräume unmittelbar aneinander grenzend ausbilden.

Gemäß einer Variante sind die optischen Elemente 3 weiterhin derart ausgebildet, dass sie außerdem noch weitere (in Fig. 4a nicht gezeigte) Flächenbereiche aufweisen, die wenigstens einen noch weiteren Steigungswinkel $\beta_i$ aufweisen, der sich von dem zuerst genannten Steigungswinkel $\beta$ und dem weiteren Steigungswinkel $\beta_1$ unterscheidet,

wobei die optischen Elemente 3 derart ausgebildet sind, dass der noch weitere Steigungswinkel $\beta_i$ bzw. gegebenenfalls jeder der noch weiteren Steigungswinkel $\beta_i$ mit Bezug auf ein lokales Maximum der Funktion $I = I(\lambda, \alpha)$, $\alpha > 0°$, das nicht das absolute Maximum und nicht das zuerst genannte lokale Maximum ist, analog zu dem zuerst genannten Steigungswinkel $\beta$ gewählt ist. Bezeichne also das Wertepaar $(\lambda_i, \alpha_i)$ die Stelle dieses lokalen Maximums der Funktion, dann ist der wenigstens eine noch weitere Steigungswinkel $\beta_i$ derart festgelegt, dass die Relation $n(\lambda_i) \sin(\beta_i - \alpha_i) = \sin(\beta_i)$ erfüllt ist, wobei $n(\lambda_i)$ den Brechungsindex der optischen Elemente 3 bei der Wellenlänge $\lambda_i$ bezeichnet. Im Allgemeinen kann also der Index $i$ ein entsprechendes lokales Maximum bezeichnen. Wenn die Funktion $I = I(\lambda, \alpha)$, $\alpha > 0°$, insgesamt $k$ lokale Maxima aufweist kann der Index $i$ dementsprechend von 1 bis $k$ laufen.

Insbesondere kann in diesem Sinne die Gestaltung derart sein, dass alle lokalen Maxima der Funktion $I = I(\lambda, \alpha)$, $\alpha > 0°$, entsprechend berücksichtigt sind, also pro Maximum ein Steigungswinkel $\beta_i$ festgelegt ist. Bezeichne $\lambda_1 \ldots \lambda_m$ alle Wellenlängen und $\alpha_1 \ldots \alpha_n$ alle Winkel, bei denen $I = I(\lambda, \alpha)$, $\alpha > 0°$ ein lokales Maximum, das nicht das absolute Maximum ist, besitzt, lassen sich im Allgemeinen $k = m \cdot n$ Steigungswinkel $\beta_i$ mit $i = 1 \ldots k = m \cdot n$ festlegen und dementsprechend weisen die optischen Elemente 3 vorzugsweise zusätzlich zu den zuerst genannten Flächenbereichen 5 mit dem Steigungswinkel $\beta$ noch weitere Flächenbereiche mit $k = m \cdot n$ unterschiedlichen Steigungen auf.

Zur Herstellung einer entsprechenden Lichtabgabeordnung wird dementsprechend in einem weiteren Schritt (iv) wenigstens ein lokales Maximum der Funktion ermittelt, das nicht das absolute Maximum darstellt, vorzugsweise des zweitgrößten Maximums und in einem noch weiteren Schritt (v) wenigstens ein weiterer Steigungswinkel $\beta_1$, $\beta_i$ in Abhängigkeit des wenigstes einen lokalen Maximums festgelegt.

In den Figuren 5a und 5b, die den Figuren 2a und 2b entsprechende Skizzen zeigen, ist ein viertes Ausführungsbeispiel dargestellt. Im Folgenden wird lediglich auf die Unterschiede zum dritten Ausführungsbeispiel eingegangen.

Bei diesem Beispiel weisen die optischen Elemente 3 jeweils zwei unterschiedliche geneigte Flächenbereiche 5, 51 auf. Hierzu kann - wie in Fig. 5a beispielhaft gezeigt - eines der optischen Elemente 3 eine Form aufweisen, die sich aus einer Pyramidenstumpf und einer auf der Deckfläche des Pyramidenstumpfes aufgesetzten Pyramide zusammensetzt, wobei die Mantelflächen des Pyramidenstumpfes den zuerst genannten Steigungswinkel $\beta$ aufweisen und die Mantelflächen der daraufgesetzten bzw. darauf angeordneten Pyramide den Steigungswinkel $\beta_1$ oder umgekehrt. Vorzugsweise wird der größere der beiden Steigungswinkel $\beta$, $\beta_1$ für die Mantelflächen des Pyramidenstumpfes gewählt und der kleinere für diejenigen der darauf angeordneten Pyramide.

Auf diese Weise lassen sich wieder alle optischen Elemente 3 mit ein und derselben Form gestalten, so dass wiederum eine quasi zweidimensionale Anordnung gleichartiger optischer Elemente 3 gebildet ist.

Die Grundflächen der optischen Elemente 3 können wiederum entweder - wie gezeigt - hexagonal sein oder aber rechteckig oder auch dreieckig.

Vorzugsweise werden auch hier wieder alle lokalen Maxima der Funktion $I = I(\lambda, \alpha)$, $\alpha > 0°$, berücksichtigt, so dass beispielsweise im Fall von zwei lokalen Maxima neben dem absoluten Maximum die optischen Elemente 3 mit zwei entsprechend aufeinander angeordneten Pyramidenstümpfen und einer darauf angeordneten Pyramide geformt sind usw.

Vorzugsweise ist bei dieser Stapelung von Pyramidenstümpfen und einer Pyramide jeweils die Grundfläche einer aufgesetzten Pyramide bzw. eines aufgesetzten Pyramidenstumpfes so groß gewählt wie die Deckfläche des unmittelbar darunter befindlichen Pyramidenstumpfes.

Es ist auch eine Mischform dieses Ausführungsbeispiel mit dem vorhergehenden Ausführungsbeispiel möglich, so dass sowohl optische Elemente mit jeweils wenigstens zwei unterschiedlich geneigten Flächenbereichen als auch optische Elemente vorhanden sind, die Flächenbereiche mit lediglich einem Steigungswinkel aufweisen. Entsprechend den obigen Ausführungen sind auch in diesem Fall die Grundflächen aller optischen Elemente vorzugsweise identisch und gleich groß gewählt.

In den Figuren 6a und 6b, die den Figuren 2a und 2b entsprechende Skizzen zeigen, ist ein viertes Ausführungsbeispiel dargestellt. Im Folgenden wird lediglich auf die Unterschiede zum vierten Ausführungsbeispiel eingegangen.

Auch bei diesem Ausführungsbeispiel ist eine quasi zweidimensionale periodische Anordnung von optischen Elementen 3 mit beispielsweise rechteckiger oder hexagonaler Grundfläche gebildet. Alle optischen Elemente 3 sind identisch geformt.

Zur Berechnung des Steigungswinkels werden jedoch nicht nur einzelne Maxima, sondern die gesamte Funktion $I = I(\lambda, \alpha)$ berücksichtigt. Die Form jedes optischen Elements 3 wird - wie in den Figuren 6a und 6b beispielhaft gezeigt - durch eine kontinuierliche stetige Anstiegsfunktion $\beta(r)$ beschrieben, wobei r den Abstand von einer Symmetrieachse Z des optischen Elements 3 bezeichnet. Die Anstiegsfunktion $\beta(r)$ wird mittels eines mathematischen Algorithmus unter Benutzung der Gleichung (1) berechnet.

Eine erfindungsgemäße Lichtabgabeanordnung eignet sich besonders gut zur Herstellung einer Leuchte, beispielsweise zur Beleuchtung eines Raums.

**Patentansprüche**

1. Lichtabgabeanordnung, aufweisend

   - eine Lichterzeugungsschicht (2) einer organischen Leuchtdiode (OLED) oder einer Quantenpunkt-Leuchtdiode (QLED), die dazu ausgebildet ist, bei Anlegen eines Stroms ein Licht zu erzeugen,
   - eine Randschicht (4), die in erster Näherung plattenförmig ist, so dass sie einen ersten Oberflächenbereich (6) und einen, dem ersten Oberflächenbereich (6) gegenüberliegenden, zweiten Oberflächenbereich (8) aufweist, wobei der zweite Oberflächenbereich (8) in erster Näherung in einer Ebene (E) verlaufend ausgebildet ist, wobei das Licht der Lichterzeugungsschicht (2) über den ersten Oberflächenbereich (6) in die Randschicht (4) eintritt, über den zweiten Oberflächenbereich (8) aus der Randschicht (4) austritt und in einen Außenraum (A) der Lichtabgabeanordnung abgegeben wird und
   - optische Elemente (3), die auf dem zweiten Oberflächenbereich (8) angeordnet oder ausgebildet sind, wobei die optischen Elemente (3) Mikroprismen sind, welche Flächenbereiche (5) aufweisen, die einen Steigungswinkel $\beta$ größer 0° gegenüber der Ebene (E) aufweisen,

   wobei der Steigungswinkel $\beta$ derart gewählt ist, dass er die Relation $n(\lambda_0)\ sin\ (\beta - \alpha_0) = sin\ (\beta)$ erfüllt, wenn die Funktion $I = I(\lambda,\ \alpha),\ \alpha > 0°$, die die Intensität $I$ des Lichts innerhalb der Randschicht (4) in Abhängigkeit der Wellenlänge $\lambda$ und des Winkels $\alpha$ angibt, unter dem sich das Licht mit Bezug auf eine, von der Lichterzeugungsschicht (2) fort weisende Normale (N) der Ebene (E) ausbreitet, bei der Wellenlänge $\lambda_0$ und dem Winkel $\alpha_0$ ihr absolutes Maximum aufweist und $n(\lambda_0)$ den Brechungsindex der Mikroprismen bei der Wellenlänge $\lambda_0$ bezeichnet, wobei die optischen Mikroprismen außerdem weitere Flächenbereiche (51) aufweisen, die einen weiteren Steigungswinkel $\beta_1$ aufweisen, der sich von dem zuerst genannten Steigungswinkel $\beta$ unterscheidet, wobei die Mikroprismen derart ausgebildet sind, dass der weitere Steigungswinkel $\beta_1$ mit Bezug auf ein lokales Maximum der Funktion $I = I(\lambda,\ \alpha),\ \alpha > 0°$, das nicht das absolute Maximum ist, analog zu dem zuerst genannten Steigungswinkel $\beta$ gewählt ist, wobei das lokale Maximum vorzugsweise das zweitgrößte Maximum der Funktion $I = I(\lambda,\ \alpha),\ \alpha > 0°$, ist.

2. Lichtabgabeanordnung nach Anspruch 1,
   bei der die Randschicht (4) durch ein Substrat gebildet ist, wobei vorzugsweise zwischen dem Substrat und der Lichterzeugungsschicht (2), insbesondere lediglich, eine Elektrode (22) der OLED bzw. QLED angeordnet ist.

3. Lichtabgabeanordnung nach Anspruch 1 oder 2,
   bei der die Mikroprismen einstückig mit der Randschicht (4) ausgebildet sind oder aus einem Material gefertigt sind, das zumindest näherungsweise denselben Brechungsindex aufweist wie dasjenige Material, aus dem die Randschicht (4) besteht.

4. Lichtabgabeanordnung nach einem der vorhergehenden Ansprüche,
   bei der der die Mikroprismen unmittelbar aneinander grenzend angeordnet sind.

5. Lichtabgabeanordnung nach einem der vorhergehenden Ansprüche,
   bei der die Größe der Mikroprismen kleiner als 1 mm ist, vorzugsweise kleiner als 0,1 mm.

6. Lichtabgabeanordnung nach einem der vorhergehenden Ansprüche,
   bei der die Mikroprismen jeweils eine Pyramidenform aufweisen, wobei die Flächenbereiche (5) jeweils wenigstens eine der Mantelflächen der entsprechenden Pyramide darstellen.

7. Lichtabgabeanordnung nach Anspruch 6,
   bei der die Pyramidenform eine dreieckige oder eine rechteckige oder eine hexagonale Grundfläche aufweist.

8. Lichtabgabeanordnung nach Anspruch 6 oder 7,
   bei der wenigstens zwei der Mantelflächen, vorzugsweise sämtliche Mantelflächen der entsprechenden Pyramide denselben Steigungswinkel $\beta$ gegenüber der Ebene (E) aufweisen.

9. Lichtabgabeanordnung nach einem der vorhergehenden Ansprüche,
   bei der die Mikroprismen außerdem noch weitere Flächenbereiche aufweisen, die wenigstens einen noch weiteren Steigungswinkel $\beta_i$ aufweisen, der sich von dem zuerst genannten Steigungswinkel $\beta$ und dem weiteren Steigungswinkel $\beta_1$ unterscheidet, wobei die Mikroprismen derart ausgebildet sind, dass der noch weitere Steigungswinkel $\beta_i$ bzw. jeder der noch weiteren Steigungswinkel $\beta_i$ mit Bezug auf ein lokales Maximum der Funktion $I = I(\lambda,\ \alpha),\ \alpha >$

*0°, das nicht das absolute Maximum und nicht das zuerst genannte lokale Maximum ist, analog zu dem zuerst genannten Steigungswinkel $\beta$ gewählt ist.*

**10.** Lichtabgabeanordnung nach Anspruch 9,
bei der die Mikroprismen derart gestaltet sind, dass zu jedem lokalen Maximum der Funktion $I = I(\lambda, \alpha)$, $\alpha > 0°$, jeweils Flächenbereiche mit einem der Steigungswinkel $\beta_1$, $\beta_i$ ausgebildet sind.

**11.** Verfahren zur Herstellung einer Lichtabgabeordnung nach einem der vorhergehenden Ansprüche, aufweisend die Schritte:

(i) Ermittlung der Funktion $I = I(\lambda, \alpha)$, $\alpha > 0°$,
(ii) Ermittlung des absoluten Maximums der Funktion,
(iii) Festlegung des Steigungswinkels $\beta$ in Abhängigkeit des absoluten Maximums der Funktion gemäß der genannten Relation.

**12.** Verfahren nach Anspruch 11,
weiterhin aufweisend die Schritte:

(iv) Ermittlung wenigstens eines lokalen Maximums der Funktion, das nicht das absolute Maximum darstellt, vorzugsweise wenigstens des zweitgrößten Maximums,
(v) analoge Festlegung wenigstens eines weiteren Steigungswinkels $\beta_1$, $\beta_i$ in Abhängigkeit des wenigstens einen lokalen Maximums.

**13.** Verfahren nach Anspruch 11 oder 12,
bei dem die Mikroprismen mithilfe von Spritzguss oder Stereolithographie hergestellt werden.

**Claims**

**1.** Light-emitting arrangement, comprising

- a light-producing layer (2) consisting of an organic light-emitting diode (OLED) or a quantum-dot light-emitting diode (QLED) which
is designed to produce a light when a current is applied,
- an edge layer (4) which, in a first approximation, is plate-shaped, so that it comprises a first surface region (6) and a second surface region (8) opposite the first surface region (6), wherein, in a first approximation, the second surface region (8) extends in a plane (*E*), wherein the light of the light-producing layer (2) enters the edge layer (4) via the first surface region (6), exits the edge layer (4) via the second surface region (8) and is emitted into an exterior space (*A*) of the light-emitting arrangement, and
- optical elements (3) which are disposed or configured on the second surface region (8), wherein the optical elements (3) are microprisms that comprise surface areas (5) having a gradient angle $\beta$ greater than 0° with respect to the plane (*E*),

wherein the gradient angle $\beta$ is selected such that it satisfies the relation $n(\lambda_0)\ sin(\beta - \alpha_0) = sin(\beta)$, if the function $I = I(\lambda, \alpha)$, $\alpha > 0°$, which specifies the intensity $I$ of the light inside the edge layer (4) as a function of the wavelength $\lambda$ and the angle $\alpha$ under which the light spreads in relation to a normal *(N)* of the plane (E) extending away from the light-producing layer (2), has its absolute maximum at the wavelength $\lambda_0$ and the angle $\alpha_0$ and $n(\lambda_0)$ is the refractive index of the microprisms at the wavelength of $\lambda_0$,
wherein the optical microprisms further comprise additional surface areas (51) having another gradient angle $\beta_1$ which differs from the first-mentioned gradient angle $\beta$, wherein the microprisms are configured such that the other gradient angle $\beta_1$ is selected in the same manner as the first-mentioned gradient angle $\beta$ *with respect to a local maximum of the function* $I = I(\lambda, \alpha)$, $\alpha > 0°$, which is not the absolute maximum, wherein the local maximum is preferably the second largest maximum of the function $I = I(\lambda, \alpha)$, $\alpha > 0°$.

**2.** Light-emitting arrangement according to Claim 1,
in which the edge layer (4) is formed by a substrate, wherein preferably in particular only an electrode (22) of the OLED or QLED is disposed between the substrate and the light-producing layer (2).

3. Light-emitting arrangement according to Claim 1 or 2, in which the microprisms are formed in one piece with the edge layer (4), or made of a material that at least approximately has the same refractive index as the material of which the edge layer (4) is made.

4. Light-emitting arrangement according to any one of the preceding Claims, in which the microprisms are arranged directly adjacent to one another.

5. Light-emitting arrangement according to any one of the preceding Claims, in which the size of the microprisms is smaller than 1 mm, preferably smaller than 0.1 mm.

6. Light-emitting arrangement according to any one of the preceding Claims, in which the microprisms all have a pyramid shape, wherein each surface area (5) represents at least one of the lateral surfaces of the corresponding pyramid.

7. Light-emitting arrangement according to Claim 6, in which the pyramid shape has a triangular or rectangular or hexagonal base.

8. Light-emitting arrangement according to Claim 6 or 7, in which at least two of the lateral surfaces, preferably all the lateral surfaces of the corresponding pyramid have the same gradient angle $\beta$ with respect to the plane (E).

9. Light-emitting arrangement according to any one of the preceding Claims, in which the microprisms also further comprise additional surface areas, which have at least one additional gradient angle $\beta_1$, which differs from the first-mentioned gradient angle $\beta$ and the other gradient angle $\beta_1$, wherein the microprisms are configured such that the other additional gradient angle $\beta_i$ or each of the other additional gradient angles $\beta_i$ is selected in the same manner as the first-mentioned gradient angle $\beta$ with respect to a local maximum of the function $I = I(\lambda, \alpha)$, $\alpha > 0°$, which is not the absolute maximum and not the first-mentioned local maximum.

10. Light-emitting arrangement according to Claim 9, in which the microprisms are configured such that surface areas having one of the gradient angles $\beta_1$, $\beta_i$ are respectively formed for each local maximum of the function $I = I(\lambda, \alpha)$, $\alpha > 0°$.

11. Method for producing a light-emitting arrangement according to any one of the preceding Claims, comprising the steps:

(i) Determining the function $I = I(\lambda, \alpha)$, $\alpha > 0°$,
(ii) Determining the absolute maximum of the function,
(iii) Defining the gradient angle $\beta$ as a function of the absolute maximum of the function according to the specified relation.

12. Method according to Claim 11, further comprising the steps:

(iv) Determining at least one local maximum of the function that is not the absolute maximum, preferably at least the second largest maximum,
(v) Analogously defining at least one additional gradient angle $\beta_1$, $\beta_i$ as a function of at least one local maximum.

13. Method according to Claim 11 or 12, in which the microprisms are produced using injection molding or stereolithography.

**Revendications**

1. Système d'émission de lumière, présentant

- une couche génératrice de lumière (2) d'une diode électroluminescente organique (OLED) ou d'une diode électroluminescente à point quantique (QLED), qui est conçue pour générer une lumière lors de l'application d'un courant,
- une couche marginale (4), qui est en première approximation en forme de plaque, de sorte qu'elle présente une première zone de surface (6) et une deuxième zone de surface (8), opposée à la première zone de surface (6), la deuxième zone de surface (8) étant conçue en première approximation dans un plan (E), la lumière de la couche génératrice de lumière (2) entrant par le biais de la première zone de surface (6) dans la couche marginale (4), sort par le biais de la seconde zone de surface (8) de la couche marginale (4) et est émise dans un espace extérieur (A) du système d'émission de lumière et

- des éléments optiques (3) disposés ou formés sur la deuxième zone de surface (8), les éléments optiques (3) étant des micro-prismes, qui présentent des zones de face (5), qui présentent un angle d'inclinaison $\beta$ supérieur à 0° par rapport au plan (E),

l'angle d'inclinaison $\beta$ étant choisi de sorte que la relation $n(\lambda_0) \, sin(\beta-\alpha_0) = sin(\beta)$ soit satisfaite, lorsque la fonction $I = I(\lambda, \alpha), \alpha > 0°$, qui indique l'intensité $I$ de la lumière au sein de la couche marginale (4) en fonction de la longueur d'onde $\lambda$ et de l'angle $\alpha$, sous laquelle la lumière s'élargit par rapport à une normale (N) du plan (E) qui fait saillie depuis la couche génératrice de lumière (2), présente à la longueur d'onde $\lambda_0$ et l'angle $\alpha_0$ son maximum absolu et $n(\lambda_0)$ désigne l'indice de réfraction des micro-prismes à la longueur d'onde $\alpha_0$,

les micro-prismes optiques présentant en outre d'autres zones de surface (51) qui présentent un autre angle d'inclinaison $\beta_1$, qui se différencie de l'angle d'inclinaison précité $\beta$, les micro-prismes étant conçus de sorte que l'angle d'inclinaison supplémentaire $\beta_1$ par rapport à un maximum local de la fonction $I = I(\lambda, \alpha), \alpha > 0°$, qui n'est pas le maximum absolu, soit choisi pour être analogue à l'angle d'inclinaison précité $\beta$ est choisi, le maximum local étant de préférence le deuxième maximum de la fonction $I = I(\lambda, \alpha), \alpha > 0°$,

**2.** Système d'émission de lumière selon la revendication 1,
dans lequel la couche marginale (4) est formée par un substrat, une, de préférence une seule, électrode (22) de l'OLED ou de la QLED étant disposée de préférence entre le substrat et la couche génératrice de lumière (2).

**3.** Système d'émission de lumière selon la revendication 1 ou 2,
dans lequel les micro-prismes sont formés d'un seul tenant avec la couche marginale (4) ou sont fabriqués en un matériau, qui présente au moins approximativement le même indice de réfraction que le matériau composant la couche marginale (4).

**4.** Système d'émission de lumière selon l'une des revendications précédentes,
dans lequel les micro-prismes sont disposés immédiatement adjacents les uns aux autres.

**5.** Système d'émission de lumière selon l'une des revendications précédentes,
dans lequel la taille des micro-prismes est inférieure à 1 mm, de préférence inférieure à 0,1 mm.

**6.** Système d'émission de lumière selon l'une des revendications précédentes,
dans lequel les micro-prismes présentent une forme pyramidale, les zones de surface (5) représentant au moins l'une des surfaces latérales de la pyramide correspondante.

**7.** Système d'émission de lumière selon la revendication 6,
dans lequel dans la forme pyramidale présente une surface de base rectangulaire ou hexagonale.

**8.** Système d'émission de lumière selon la revendication 6 ou 7,
dans lequel au moins deux des surfaces latérales, de préférence toutes les surfaces latérales de la pyramide correspondante présentent le même angle d'inclinaison $\beta$ par rapport au plan (E).

**9.** Système d'émission de lumière selon l'une des revendications précédentes,
dans lequel les micro-prismes présentent en outre encore d'autres zones de surface, qui présentent au moins un autre d'angle d'inclinaison $\beta_i$, qui se différencie de l'angle d'inclinaison précité $\beta$ et de l'angle d'inclinaison supplémentaire $\beta_1$, les micro-prismes étant conçus de sorte que l'autre angle d'inclinaison $\beta_i$ ou chacun des autres angles d'inclinaison $\beta_1$ soit choisi par rapport à un maximum local de la fonction $I = I(\lambda, \alpha), \alpha > 0°$, qui n'est pas le maximum absolu et pas le maximum local précité, pour être analogue à l'angle d'inclinaison précité $\beta$.

**10.** Système d'émission de lumière selon la revendication 9,
dans lequel les micro-prismes sont agencés de sorte que, pour chaque maximum local de la fonction $I = I(\lambda, \alpha), \alpha > 0°$, des zones de surface respectives avec un angle d'inclinaison $\beta_1, \beta_i$ soient formés.

**11.** Procédé de fabrication d'un système d'émission de lumière selon l'une des revendications précédentes, présentant les étapes suivantes :

(i) détermination de la fonction $I = I(\lambda, \alpha)$, $\alpha > 0°$,
(ii) détermination du maximum absolu de la fonction,
(iii) spécification de l'angle d'inclinaison $\beta$ en fonction du maximum absolu de la fonction selon la relation mentionnée.

**12.** Procédé selon la revendication 11, présentant en outre les étapes suivantes :

(iv) détermination au moins d'un maximum local de la fonction, qui ne représente pas le maximum absolu, de préférence au moins le deuxième maximum,
(v) spécification analogue d'au moins d'un autre angle d'inclinaison $\beta_1$, $\beta_i$ en fonction du au moins un maximum local.

**13.** Procédé selon la revendication 11 ou 12,
dans lequel les micro-prismes sont fabriqués par moulage par injection ou par stéréo-lithographie.

Fig. 1

Fig. 2a

Fig. 2b

Fig. 3a

Fig. 3b

Fig. 4a

Fig. 4b

Fig. 5a

Fig. 5b

Fig. 6a

Fig. 6b

Fig. 7
(Stand der Technik)

Fig. 8

A

α < α_c    α > α_c

N

β'

Luft    8

α    α

α    α

Substrat    4

Fig. 9

Intensität

λ_1    λ_2    λ_3    Wellenlänge

Fig. 10

Intensität

λ_2

λ_1

0°    α_{1,1}  α_{2,1}    α_{1,2}    Winkel

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20030020399 A1
- EP 1486802 A1
- US 20070230211 A1
- US 20070046181 A1